# EUROPEAN PATENT APPLICATION

(11) **EP 4 701 361 A1**
(43) Date of publication of application: **25.02.2026**
(21) Application number: 25189607.2
(22) Date of filing: 15.07.2025
(51) Int. Cl.: H10B 12/00, H10P 32/14, H10P 32/10

(54) **SEMICONDUCTOR MEMORY DEVICES**

(30) Priority: 13.08.2024 KR 20240108497
(71) Applicant: Samsung Electronics Co., Ltd., Suwon-si, Gyeonggi-do 16677 (KR)
(72) Inventor: JANG, Sunghwan, 16677 Suwon-si (KR); PARK, Hyojin, 16677 Suwon-si (KR)
(74) Representative: Marks & Clerk LLP

(57) **Abstract**

A semiconductor memory device includes a substrate, a first semiconductor pattern and a second semiconductor pattern, the first semiconductor pattern and the second semiconductor pattern extending in a first horizontal direction above the substrate, and spaced apart from each other, the first semiconductor pattern comprising a channel region, a source region, and a drain region, the channel region, source region, and drain region arranged in the first horizontal direction with the channel region therebetween, a first word line and a second word line, the first word line and the second word line extending in the second horizontal direction above the first semiconductor pattern, and spaced apart from each other in the vertical direction, a bit line connected to the source region of the first semiconductor pattern, and the bit line extending in the vertical direction, and a cell capacitor connected to the drain region of the first semiconductor pattern.

## Description

### BACKGROUND

Some example embodiments of the inventive concepts relate to a semiconductor memory device, and more particularly, to a 3-dimensional semiconductor memory device.

In the semiconductor manufacturing industry, there is a desire for miniaturization, multifunctionality, and higher performance in electronic products utilizing high-capacity semiconductor memory devices. To this end, increased degrees of integration are expected to provide higher-capacity semiconductor memory devices. 3-dimensional semiconductor memory devices to increase memory capacities by stacking a plurality of memory cells in a vertical direction on a substrate have been proposed.

### SUMMARY

Some example embodiments of the inventive concepts provide a 3-dimensional semiconductor memory device including a spacer layer that is located between a bit line and a source region and contains a high concentration of impurities.

The objects of the inventive concepts are not limited to the object mentioned above, but other objects not described herein will be clearly understood by those skilled in the art from the following description.

According to some example embodiments of the inventive concepts, there is provided a semiconductor memory device including a first substrate, a first semiconductor pattern and a second semiconductor pattern, the first semiconductor pattern and the second semiconductor pattern extending in a first horizontal direction above the first substrate, and spaced apart from each other in a second horizontal direction and a vertical direction, the second horizontal direction and vertical direction intersecting the first horizontal direction, the first semiconductor pattern comprising a channel region, a source region, and a drain region, the channel region, source region, and drain region arranged in the first horizontal direction with the channel region therebetween, a first word line and a second word line, the first word line and the second word line extending in the second horizontal direction above the first semiconductor pattern, and spaced apart from each other in the vertical direction, a bit line connected to the source region of the first semiconductor pattern, and the bit line extending in the vertical direction, a cell capacitor connected to the drain region of the first semiconductor pattern; and a spacer layer located between the first semiconductor pattern and the bit line, and the spacer layer comprising a high concentration of impurities.

The spacer layer may have a relatively high concentration of impurities (e.g. a high concentration of impurities relative to the source region of the first semiconductor pattern). The spacer layer may have a higher concentration of impurities than the source region. The spacer layer and source region may both comprise first impurities (e.g. impurities of the same element). The concentration of first impurities in the spacer layer may be higher than the concentration of first impurities in the source region.

The concentration of impurities in the source region may vary depending on distance from the spacer layer. For instance, the concentration of impurities may reduce with increasing distance from the spacer layer (e.g. at least in a region adjacent to (e.g. surrounded by) the spacer layer).

The spacer layer may be located adjacent to the source region. For instance, the spacer layer may be located one or more of above, below and to the side of the source region. The spacer layer may contact (e.g. directly contact) the source region. The semiconductor pattern may penetrate the spacer layer. The semiconductor pattern may contact (e.g. directly contact) the bit line.

The first word line and the second word line may extend in the second horizontal direction above the first semiconductor pattern and the second semiconductor pattern, respectively. A first gate insulating layer may be located between (e.g. may physically connect) the first word line and the first semiconductor pattern. A second gate insulating layer may be located between (e.g. may physically connect) the second word line and the second semiconductor pattern.

According to some example embodiments of the inventive concepts there is provided a semiconductor memory device comprising: a first substrate; a first semiconductor pattern on the first substrate, the first semiconductor pattern extending in a first direction, a first word line extending across the first semiconductor pattern in a second direction that intersects the first direction, a bit line, a storage element and a spacer layer. The first semiconductor pattern comprises a channel region, a source region, and a drain region, the channel region, source region, and drain region being arranged in the first horizontal direction with the channel region therebetween. The bit line is connected to the source region of the first semiconductor pattern. The bit line extends in a third direction that intersects the first direction and the second direction. The storage element is connected to the drain region of the first semiconductor pattern. The spacer layer covers at least a portion of the source region. The spacer layer may be in contact with the at least a portion of the source region. The spacer layer may contact one or more of an upper surface, a lower surface, a first side surface and a second side surface of the source region. The spacer layer may comprise a higher concentration of impurities than the source region.

The storage element may comprise one of a cell capacitor, a magnetic tunnel junction, or a variable resistor comprising a phase-change material.

The first direction and the second direction may be horizontal directions (e.g. directions parallel to an upper surface of the first substrate). The third direction may be a vertical direction (e.g. a direction perpendicular to the upper surface of the first substrate). However, in alternative embodiments, the first direction is a vertical direction and the second and third directions are horizontal directions. Furthermore, in alternative embodiments, the second direction is a vertical direction and the first and third directions are horizontal directions.

According to some example embodiments of the inventive concepts, there is provided a semiconductor memory device including a first substrate, a first semiconductor pattern and a second semiconductor pattern, the first semiconductor pattern and the second semiconductor pattern extending in a first horizontal direction above the first substrate, and spaced apart from each other in a second horizontal direction and a vertical direction, the second horizontal direction and the vertical direction intersecting the first horizontal direction, the first semiconductor pattern comprising a channel region, a source region, and a drain region, the channel region, source region, and drain region arranged in the first horizontal direction with the channel region therebetween, a first word line and a second word line, the first word line and the second word line extending in the second horizontal direction above the first semiconductor pattern, and spaced apart from each other in the vertical direction, a bit line connected to the source region of the first semiconductor pattern, and the bit line extending in the vertical direction, a cell capacitor connected to the drain region of the first semiconductor pattern, a spacer layer located on a first sidewall of the bit line, and the spacer layer partially covering the source region of the first semiconductor pattern, and an isolation-insulating layer located on a second sidewall of the bit line opposite to the first sidewall. The source region of the first semiconductor pattern comprises same impurities as impurities of the spacer layer.

According some example embodiments of the inventive concepts, there is provided a semiconductor memory device including a first stack structure including a first stack structure comprising a memory cell region comprising a plurality of memory cells and a plurality of cell capacitors arranged in three dimensions, and a second stack structure on the first stack structure, the second stack structure comprising a peripheral circuit region located at a position vertically overlapping the plurality of memory cells, and the second stack structure electrically connected to the plurality of memory cells. The first stack structure comprises a first substrate, a first semiconductor pattern and a second semiconductor pattern, the first semiconductor pattern and the second semiconductor pattern extending in a first horizontal direction above the first substrate, and spaced apart from each other in a second horizontal direction and a vertical direction, the second horizontal direction and the vertical direction intersecting the first horizontal direction, the first semiconductor pattern comprising a channel region, a source region, and a drain region, the channel region, source region, and drain region arranged in the first horizontal direction with the channel region therebetween, a word line surrounding the first semiconductor pattern and extending in the second horizontal direction, a bit line connected to the source region of the first semiconductor pattern and extending in the vertical direction, the plurality of cell capacitors each connected to the drain region of the first semiconductor pattern, a spacer layer located on a sidewall of the bit line and partially covering the source region of the first semiconductor pattern, and the source region of the first semiconductor pattern comprising same impurities as impurities of the spacer layer.

At least some of the above and other features of the invention are set out in the claims.

### BRIEF DESCRIPTION OF THE DRAWINGS

Example embodiments will be more clearly understood from the following detailed description taken in conjunction with the accompanying drawings in which:
FIG. 1 is a block diagram schematically showing a semiconductor memory device according to some example embodiments;
FIG. 2 is a circuit diagram showing a memory cell region illustrated in FIG. 1;
FIG. 3 is a schematic perspective view showing a memory cell region of a semiconductor memory device according to some example embodiments;
FIG. 4 is a cross-sectional view of a semiconductor memory device taken along line A1-A1' of FIG. 3;
FIG. 5 is a cross-sectional view of a semiconductor memory device taken along line B1-B1' of FIG. 3;
FIG. 6 is an enlarged view of region CX1 of FIG. 4;
FIG. 7 is a layout view schematically showing a semiconductor memory device according to some example embodiments;
FIG. 8 is a schematic perspective view showing a memory cell region of a semiconductor memory device according to some example embodiments;
FIG. 9 is a cross-sectional view of a semiconductor memory device taken along line A2-A2' of FIG. 8; and
FIGS. 10 to 16 are schematic views showing a method of manufacturing a semiconductor memory device, according to some example embodiments.

### DETAILED DESCRIPTION

Hereinafter, some example embodiments of the inventive concepts are described in detail with reference to the accompanying drawings. The same reference numerals are given to the same elements in the drawings, and repeated descriptions thereof are omitted.

As used herein, the singular forms "a", "an", and "the" are intended to include the plural forms as well, unless the context clearly indicates otherwise. Additionally, the description may be specific to a portion of the semiconductor device and the described structure may be repeated in other portions of the semiconductor device. For example, the described structure may be an individual element of an array of elements forming the semiconductor device. Accordingly, where the structure of a single element of a plurality of elements has been described, this structure may equally apply to other elements of the plurality of elements.

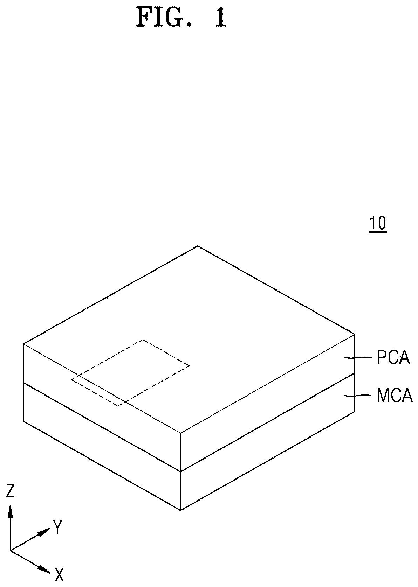

FIG. 1 is a block diagram schematically showing a semiconductor memory device 10 according to some example embodiments.

Referring to FIG. 1, the semiconductor memory device 10 may include a memory cell region MCA and a peripheral circuit region PCA at a higher vertical level than the memory cell region MCA.

In some example embodiments, the memory cell region MCA may include a memory cell region of a dynamic random-access memory (DRAM) device, and the peripheral circuit region PCA may include a core region or a peripheral circuit region of the DRAM device. For example, the peripheral circuit region PCA may include a peripheral circuit transistor for transmitting a signal and/or power to a memory cell array of the memory cell region MCA. In some example embodiments, peripheral circuit transistors may constitute various circuits, such as a command decoder, control logic, an address buffer, a row decoder, a column decoder, a sense amplifier, and a data input/output circuit.

Relative vertical levels may be defined along a vertical direction (e.g. a Z-direction) that runs perpendicular to a substrate (e.g. a substrate of one of the memory cell region MCA or the peripheral circuit region PCA). Horizontal directions may be defined parallel to the substrate. In FIG. 1, a case in which the peripheral circuit region PCA is at a higher vertical level than the memory cell region MCA is illustrated as an example (e.g., a case in which the peripheral circuit region PCA is disposed on the memory cell region MCA). However, in some example embodiments, the semiconductor memory device 10 may be arranged upside down so that the memory cell region MCA is at a higher vertical level than the peripheral circuit region PCA. It will be appreciated that the relative positions and directions described herein are described relative to the structure of the device, and therefore need not limit the orientation of the device in use.

In some example embodiments, the peripheral circuit region PCA and the memory cell region MCA are respectively formed on separate wafers, and then the peripheral circuit region PCA and the memory cell region MCA may be attached to each other using bonding pads. In some example embodiments, a peripheral circuit region PCA may be formed first on a peripheral circuit wafer, and then a memory cell region MCA may be formed on the peripheral circuit region PCA.

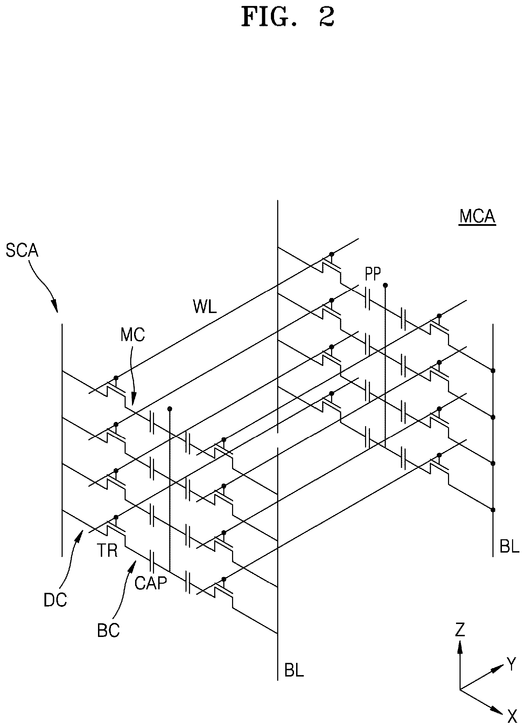

FIG. 2 is a circuit diagram showing a memory cell region MCA illustrated in FIG. 1.

Referring to FIG. 2, the memory cell region MCA may include a plurality of sub cell arrays SCA. The plurality of sub cell arrays SCA may be arranged in a second horizontal direction Y.

In some example embodiments, the sub cell arrays SCA may include a plurality of bit lines BL, a plurality of word lines WL, and a plurality of memory cells MC. Each of the plurality of memory cells MC may include one cell transistor TR and one cell capacitor CAP connected thereto. Each of the plurality of memory cells MC may have a 1 transistor-1 capacitor (1T1C) structure.

In some example embodiments, the plurality of word lines WL may each extend in the second horizontal direction Y and may be spaced apart from each other in a first horizontal direction X and a vertical direction Z. The plurality of bit lines BL may each extend in the vertical direction Z and may be spaced apart from each other in both the first horizontal direction X and the second horizontal direction Y. One cell transistor TR may be located between one word line WL and one bit line BL. The first horizontal direction (otherwise known as a first direction) may run parallel to an upper surface of a substrate (e.g. a surface upon which the sub cell arrays are located). The second horizontal direction (otherwise known as a second direction) may run parallel to the upper surface of the substrate. The vertical direction (otherwise known as a third direction) may run perpendicular to the upper surface of the substrate. The first direction, the second direction, and the third direction may intersect each other (e.g. may be perpendicular to each other).

In some example embodiments, a gate of the cell transistor TR may be connected to the word line WL, and a source of the cell transistor TR may be connected to the bit line BL via a first contact DC. The cell transistor TR may be connected to the cell capacitor CAP via a second contact BC. A drain of the cell transistor TR may be connected to a first electrode of the cell capacitor CAP via the second contact BC, and a second electrode of the cell capacitor CAP may be connected to a plate electrode PP.

In some example embodiments, in one sub cell array SCA, the plurality of cell transistors TR may be arranged at positions that overlap each other in the vertical direction Z. In one sub cell array SCA, the plurality of cell capacitors CAP may be arranged at positions that overlap each other in the vertical direction Z. One cell transistor TR and one cell capacitor CAP may be arranged side by side at the same vertical level, and the plurality of memory cells MC each including one cell transistor TR and one cell capacitor CAP may be stacked in the vertical direction Z. The storage capacity of the sub cell array SCA may vary depending on the number of memory cells MC or the number of layers thereof (e.g., the number of cell capacitors CAP or the number of layers thereof) stacked in the vertical direction Z.

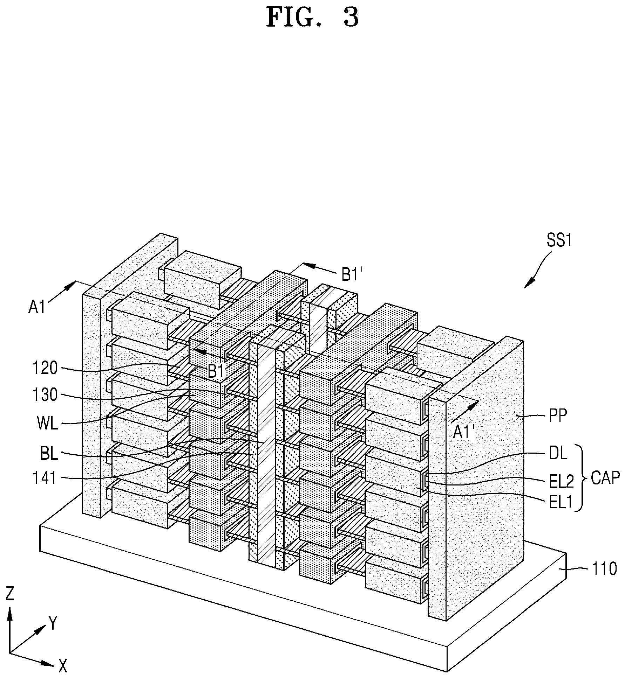

FIG. 3 is a schematic perspective view showing a memory cell region of a semiconductor memory device according to some example embodiments.

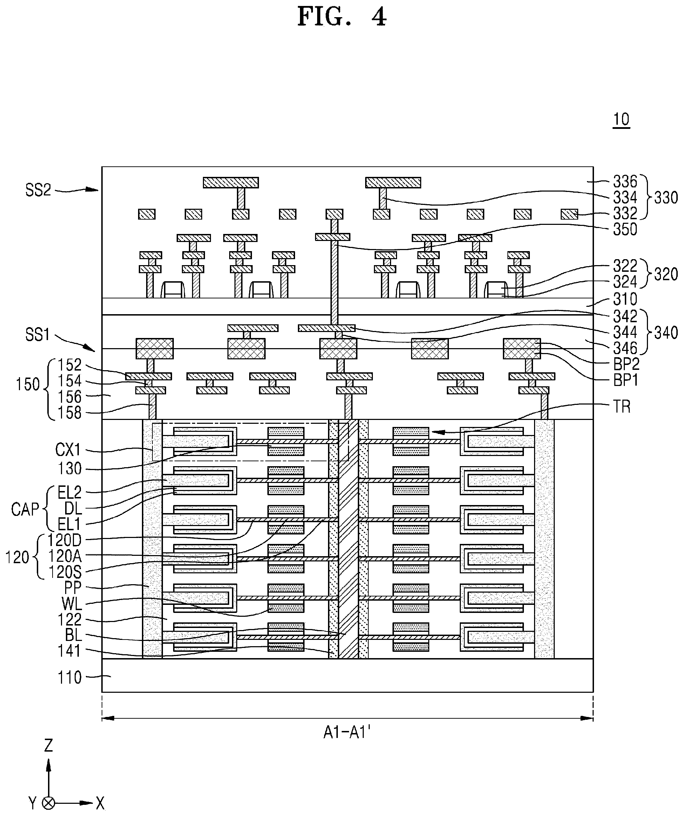

FIG. 4 is a cross-sectional view of the semiconductor memory device taken along line A1-A1' of FIG. 3.

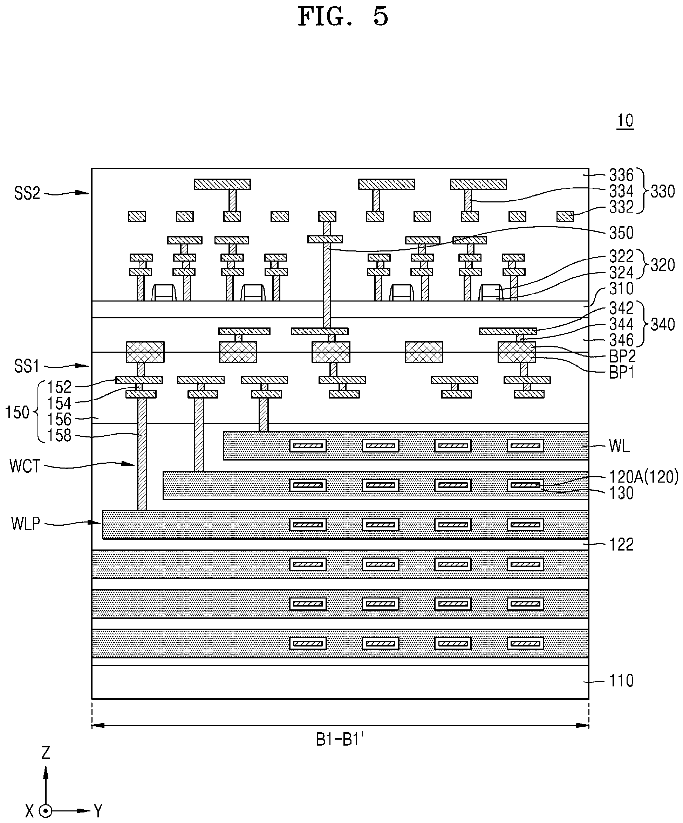

FIG. 5 is a cross-sectional view of the semiconductor memory device taken along line B1-B1' of FIG. 3.

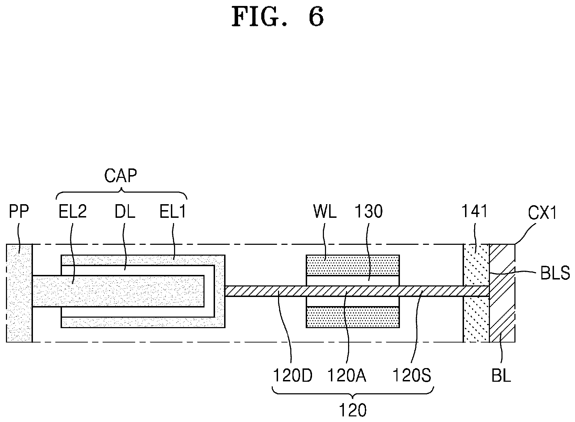

FIG. 6 is an enlarged view of region CX1 of FIG. 4.

Referring to FIGS. 3 to 6, a semiconductor memory device 10 may include a first stack structure SS1 and a second stack structure SS2, and the second stack structure SS2 may be bonded to the first stack structure SS1 by a first bonding pad BP1 and a second bonding pad BP2.

In some example embodiments, the first stack structure SS1 may include a first substrate 110, a plurality of semiconductor patterns 120 arranged above the first substrate 110, a plurality of bit lines BL, a plurality of word lines WL, and a plurality of cell capacitors CAP.

In some example embodiments, the first substrate 110 may include Si, Ge, or SiGe. In some example embodiments, the first substrate 110 may include a silicon-on-insulator (SOI) substrate or a germanium-on-insulator (GeOI) substrate. However, example embodiments are not limited thereto.

In some example embodiments, the plurality of semiconductor patterns 120 may extend in the first horizontal direction X above the first substrate 110 and be spaced apart from each other in the vertical direction Z.

In some example embodiments, the plurality of semiconductor patterns 120 may include, for example, undoped semiconductor materials or doped semiconductor materials. In some example embodiments, the plurality of semiconductor patterns 120 may include polysilicon. In some example embodiments, the plurality of semiconductor patterns 120 may include amorphous metal oxide, polycrystalline metal oxide, or combinations of the amorphous metal oxide and the polycrystalline metal oxide, and may include, for example, at least one of In-Ga-based oxide (IGO), In-Zn-based oxide (IZO), and In-Ga-Zn-based oxide (IGZO). In some example embodiments, the plurality of semiconductor patterns 120 may include 2D material semiconductors. For example, the 2D material semiconductors may include MoS₂, WSe₂, Graphene, Carbon Nano Tube, or a combination thereof. However, example embodiments are not limited thereto.

In some example embodiments, each of the plurality of semiconductor patterns 120 may have a line shape or a bar shape extending in the first horizontal direction X. In some example embodiments, each of the semiconductor patterns 120 may include a channel region 120A, and a source region 120S and a drain region 120D arranged in the first horizontal direction X with the channel region 120A therebetween. The source region 120S may be connected to the bit line BL, and the drain region 120D may be connected to the cell capacitor CAP. An ohmic metal layer including metal silicide or the like may be further formed between the source region 120S and the bit line BL and between the drain region 120D and the cell capacitor CAP. However, example embodiments are not limited thereto.

In some example embodiments, the plurality of bit lines BL may each extend in the vertical direction Z above the first substrate 110 and may be spaced apart from each other in the second horizontal direction Y. In this case, the bit line BL may include metal. For example, the bit line BL may include metal, such as Ti, Ta, Mo, Ru, W, Co, Al, and Ni, conductive metal nitride, such as TiN, TaN, WN, RuTiN, TiSiN, WSiN, and TaSiN, metal silicide, such as TiSi, WSi, TaSi, CoSi, and NiSi, or a combination thereof, but example embodiments are not limited thereto.

In some example embodiments, the source region 120S and drain region 120D of the semiconductor pattern 120 may be doped with first impurities. The channel region 120A may be doped with second impurities that are different from the first impurities. For example, the source region 120S and the drain region 120D may each be of a first conductivity type due to the first impurities, and the channel region 120A may be of a second conductivity type that is different from the first conductivity type due to the second impurities.

In some example embodiments, the first conductivity type may represent n type and the second conductivity type may represent p type, but example embodiments are not limited thereto. For example, the first conductivity type may represent p type and the second conductivity type may represent n type. When the first conductivity type represents n type, the first impurities may include phosphorus (P), arsenic (As), or antimony (Sb). Also, when the second conductivity type represents p type, the second impurities may include boron (B), aluminum (Al), gallium (Ga), or indium (In). For example, the source region 120S and drain region 120D of the semiconductor pattern 120 may be doped with phosphorus (P). However, example embodiments are not limited thereto.

In some example embodiments, a spacer layer 141 may be located between the bit line BL and the semiconductor pattern 120. Specifically, the spacer layer 141 may be located between the bit line BL and the source region 120S. The spacer layer 141 may be located between the bit line BL and the source region 120S in that a straight line may be drawn between a point in the bit line BL and a point in the source region 120S such that the straight line intersects a point in the spacer layer 141. The spacer layer 141 may extend in the vertical direction Z on a sidewall BLS of the bit line BL. The spacer layer 141 may cover the sidewall BLS of the bit line BL and may partially cover the source region 120S. For example, the spacer layer 141 may cover a portion of the upper surface and a portion of the lower surface of the source region 120S. In some example embodiments, a spacer layer 141 may surround one end of the source region 120S. The spacer layer 141 may at least partially wrap around the source region 120S. For example, the spacer layer 141 may cover a portion of the upper surface, a portion of the lower surface, and a portion of the sidewall(s) of the source region 120S. That is, the source region 120S may pass through the spacer layer 141 and one end thereof may be connected to the bit line BL.

In some example embodiments, a pair of spacer layers 141 may be spaced apart from each other in the first horizontal direction X with the bit line BL therebetween. Also, a plurality of spacer layers 141 may each extend in the vertical direction Z above the first substrate 110 and may be spaced apart from each other in the second horizontal direction Y.

In some example embodiments, the spacer layer 141 may include an insulating material containing a high concentration of impurities. The term "high concentration" may refer to a concentration of impurities relative to the concentration of impurities in the source region 120S. For instance, the spacer layer 141 may have a higher concentration of impurities than the source region 120S. The impurities in the spacer layer 141 may be the same as the impurities in the source region 120S. For example, the spacer layer 141 may include the first impurities. The concentration of first impurities in the spacer layer 141 may be higher than the concentration of first impurities in the source region 120S.

In some example embodiments, the spacer layer 141 may include a high concentration of phosphorus (P). For example, the spacer layer 141 may include phosphorus silicate glass (PSG). However, example embodiments are not limited thereto. When the spacer layer 141 includes PSG, the source region 120S may be of n type as the first conductivity type.

In some example embodiments, the spacer layer 141 may include a high concentration of boron (B). For example, the spacer layer 141 may include boron silicate glass (BSG). However, example embodiments are not limited thereto. When the spacer layer 141 includes BSG, the source region 120S may be of p type as the first conductivity type.

In some example embodiments, the concentration of impurities in the spacer layer 141 may be higher than the concentration of impurities in the source region 120S. For example, the first concentration, which is a concentration of phosphorus (P) in the spacer layer 141, may be higher than a second concentration, which is a concentration of phosphorus (P) in the source region 120S. Also, a third concentration, which is a concentration of boron (B) in the spacer layer 141, may be higher than a fourth concentration, which is a concentration of boron (B) in the source region 120S. Since the concentration of impurities in the spacer layer 141 is higher than the concentration of impurities in the source region 120S, the impurities (e.g., phosphorus or boron) may diffuse from the spacer layer 141 to the source region 120S. Due to this diffusion, the concentration of impurities in the source region 120S may vary depending on distance from the spacer layer 141. For instance, the concentration of impurities may reduce with increasing distance from the spacer layer 141 (e.g. at least in the region adjacent to the spacer layer 141).

In some example embodiments, the semiconductor memory device 10 according to the inventive concepts may include the spacer layer 141 containing a high concentration of impurities, and the spacer layer 141 is adjacent to the source region 120S. Accordingly, the source region 120S may be doped with impurities by the spacer layer 141. In a semiconductor memory device according to a comparative example, a source region is formed using only gas phase doping (GPD). Accordingly, the reliability of the semiconductor memory device is degraded due to impurity loss during a process (e.g., heat treatment). In the semiconductor memory device 10 according to the inventive concepts, impurities are continuously supplied to the source region 120S by using the spacer layer 141 containing a high concentration of impurities. Accordingly, the reliability of the semiconductor memory device 10 may be improved.

Also, the source region 120S is doped with impurities by using the spacer layer 141, and the resistance of the bit line BL may be lowered by using the bit line BL including metal.

In some example embodiments, the plurality of word lines WL may each extend in the second horizontal direction Y above the semiconductor patterns 120 and may be spaced apart from each other in the vertical direction Z. The plurality of word lines WL may each have a gate all around (GAA) structure that surrounds each of the plurality of semiconductor patterns 120 and extends in the second horizontal direction Y. For instance, each wordline WL may extend across a corresponding subset of semiconductor patterns 120 that are located on the same vertical level and that are arranged relative to each other in the second horizontal direction Y. The wordline WL may surround each of the corresponding subset of semiconductor patterns 120. The wordline WL may surround a semiconductor pattern 120 in that it may cover upper, lower and first and second side surfaces of the semiconductor pattern (e.g. first and second side surfaces in the second horizontal direction Y).

In some example embodiments, the plurality of word lines WL may each have a double word line structure in which a pair of word lines are spaced apart from each other in the vertical direction Z with the semiconductor pattern 120 therebetween. In this case, each pair of word lines may extend across (e.g. above and below) each of the corresponding subset of semiconductor patterns 120. In some example embodiments, the plurality of word lines WL may each have a single word line structure which includes only one word line WL disposed above the semiconductor pattern 120. In this case, each single word line structure may extend across (e.g. above) each of the corresponding subset of semiconductor patterns 120.

In some example embodiments, the plurality of word lines WL may include at least one of doped semiconductor materials (doped silicon, doped germanium, etc.), conductive metal nitride (titanium nitride, tantalum nitride, etc.), metal (tungsten, titanium, tantalum, etc.), and metal-semiconductor compounds (tungsten silicide, cobalt silicide, titanium silicide, etc.). However, example embodiments are not limited thereto.

In some example embodiments, a gate insulating layer 130 may be located between the word line WL and the semiconductor pattern 120. The gate insulating layer 130 may include at least one selected from a group consisting of a ferroelectric material and a high-k dielectric material (e.g. a material having a higher dielectric constant than silicon oxide). In some example embodiments, the gate insulating layer 130 includes at least one selected from a group consisting of hafnium oxide (HfO), hafnium silicate (HfSiO), hafnium oxynitride (HfON), hafnium silicon oxynitride (HfSiON), lanthanum oxide (LaO), lanthanum aluminum oxide (LaAlO), zirconium oxide (ZrO), zirconium silicate (ZrSiO), zirconium oxynitride (ZrON), zirconium silicon oxynitride (ZrSiON), tantalum oxide (TaO), titanium oxide (TiO), barium strontium titanium oxide (BaSrTiO), barium titanium oxide (BaTiO), lead zirconate titanate (PZT), strontium bismuth tantalate (STB), bismuth iron oxide (BFO), strontium titanium oxide (SrTiO), yttrium oxide (YO), aluminum oxide (AlO), and lead scandium tantalum oxide (PbScTaO). However, example embodiments are not limited thereto.

In some example embodiments, the cell capacitor CAP may include a first electrode EL1, a capacitor dielectric layer DL, and a second electrode EL2. First electrodes EL1 may each extend in the first horizontal direction X and may be spaced apart from each other in the vertical direction Z. The first electrode EL1 may have an inner space (not shown) extending in the first horizontal direction X, and the inner space thereof may be filled with the capacitor dielectric layer DL and the second electrode EL2. For example, the first electrode EL1 may have a cup shape rotated by 90 degrees.

In some example embodiments, the capacitor dielectric layer DL may include at least one selected from a group consisting of a ferroelectric material and a high-k dielectric material (e.g. a material having a higher dielectric constant than silicon oxide). In some example embodiments, the capacitor dielectric layer DL includes at least one selected from a group consisting of hafnium oxide (HfO), hafnium silicate (HfSiO), hafnium oxynitride (HfON), hafnium silicon oxynitride (HfSiON), lanthanum oxide (LaO), lanthanum aluminum oxide (LaAlO), zirconium oxide (ZrO), zirconium silicate (ZrSiO), zirconium oxynitride (ZrON), zirconium silicon oxynitride (ZrSiON), tantalum oxide (TaO), titanium oxide (TiO), barium strontium titanium oxide (BaSrTiO), barium titanium oxide (BaTiO), lead zirconate titanate (PZT), strontium bismuth tantalate (STB), bismuth iron oxide (BFO), strontium titanium oxide (SrTiO), yttrium oxide (YO), aluminum oxide (AlO), and lead scandium tantalum oxide (PbScTaO). However, example embodiments are not limited thereto.

In some example embodiments, the second electrode EL2 may fill the inner space of the first electrode EL1, and the capacitor dielectric layer DL may be located between the second electrode EL2 and the inner space of the first electrode EL1.

In some example embodiments, the first electrode EL1 and the second electrode EL2 may include doped semiconductor materials, conductive metal nitride, such as titanium nitride, tantalum nitride, niobium nitride, and tungsten nitride, metal, such as ruthenium, iridium, titanium, and tantalum, and conductive metal oxide, such as iridium oxide and niobium oxide. However, example embodiments are not limited thereto.

In some example embodiments, the plate electrode PP may extend in the vertical direction Z and the second horizontal direction Y on one side of the cell capacitor CAP. The second electrode EL2 of the cell capacitor CAP may be electrically connected to the plate electrode PP. For example, the plurality of second electrodes EL2 spaced apart from each other in the vertical direction Z and the plurality of second electrodes EL2 spaced apart from each other in the second horizontal direction Y may be connected to the plate electrode PP in common.

In some example embodiments, a mold insulating layer 122 may be located between two adjacent semiconductor patterns 120 spaced apart from each other in the vertical direction Z, between two adjacent word lines WL spaced apart from each other in the vertical direction Z, and between two adjacent first electrodes EL1 spaced apart from each other in the vertical direction Z. In addition, the mold insulating layer 122 may also be located between two bit lines BL spaced apart from each other in the second horizontal direction Y. In addition, the mold insulating layer 122 may also be located between two spacer layers 141 spaced apart from each other in the second horizontal direction Y.

In some example embodiments, the mold insulating layer 122 may include silicon oxide, silicon oxynitride, silicon nitride, carbon-containing silicon oxide, carbon-containing silicon oxynitride, carbon-containing silicon nitride, or a combination thereof. However, example embodiments are not limited thereto. In some example embodiments, the mold insulating layer 122 may include a plurality of insulating layers. Herein, depending on manufacturing processes employed to form 3-dimensional structures, insulating material layers formed between the plurality of bit lines BL, between the plurality of spacer layers 141, between the plurality of word lines WL, between the plurality of semiconductor patterns 120, and between the plurality of cell capacitors CAP may be collectively referred to as the mold insulating layer 122.

In some example embodiments, the first stack structure SS1 may include an upper wiring structure 150. The upper wiring structure 150 may include a wiring layer 152, a via 154, and an insulating layer 156. The upper wiring structure 150 may further include a contact 158 electrically connected to the bit line BL, the word line WL, and the plate electrode PP. Also, the first bonding pad BP1 may be formed on the upper wiring structure 150 and may be on the same plane as the uppermost surface of the insulating layer 156.

In some example embodiments, the second stack structure SS2 may include a second substrate 310, a peripheral circuit transistor 320 disposed on the second substrate 310, a front wiring structure 330 covering the peripheral circuit transistor 320 on the upper surface of the second substrate 310, and a rear wiring structure 340 disposed on the bottom surface of the second substrate 310. The front wiring structure 330 may include a wiring layer 332, a via 334, and an insulating layer 336, and the rear wiring structure 340 may include a wiring layer 342, a via 344, and an insulating layer 346.

In some example embodiments, the rear wiring structure 340 may include the second bonding pad BP2 on the same plane as the bottom surface of the insulating layer 346, and the first stack structure SS1 and the second stack structure SS2 may be bonded to each other as the first bonding pad BP1 and the second bonding pad BP2 are connected to each other. In some example embodiments, the first stack structure SS1 and the second stack structure SS2 may be attached to each other by a copper-oxide hybrid bonding method. In some example embodiments, the first bonding pad BP1 and the second bonding pad BP2 may include copper or a copper alloy. An interface between the insulating layer 156 of the upper wiring structure 150 and the insulating layer 346 of the rear wiring structure 340 may extend in a flat shape, and this interface may be on the same plane as an interface between the first bonding pad BP1 and the second bonding pad BP2.

In some example embodiments, the peripheral circuit transistor 320 may include a gate electrode 322 and a gate insulating layer 324 disposed on an active region of the second substrate 310. In some example embodiments, the peripheral circuit transistor 320 may include sense amplifiers, and the sense amplifiers may be electrically connected to the bit lines BL of the first stack structure SS1. In addition, the peripheral circuit transistor 320 may include sub-word line drivers, and the sub-word line drivers may be electrically connected to the word lines WL of the first stack structure SS1.

In some example embodiments, the second stack structure SS2 may further include a through-via 350 passing through the second substrate 310. The wiring layer 332 in the front wiring structure 330 may be electrically connected to the wiring layer 342 in the rear wiring structure 340 by the through-via 350. In addition, the wiring layer 342 in the rear wiring structure 340 may be electrically connected to the wiring layer 152 in the upper wiring structure 150 via the second bonding pad BP2 and the first bonding pad BP1.

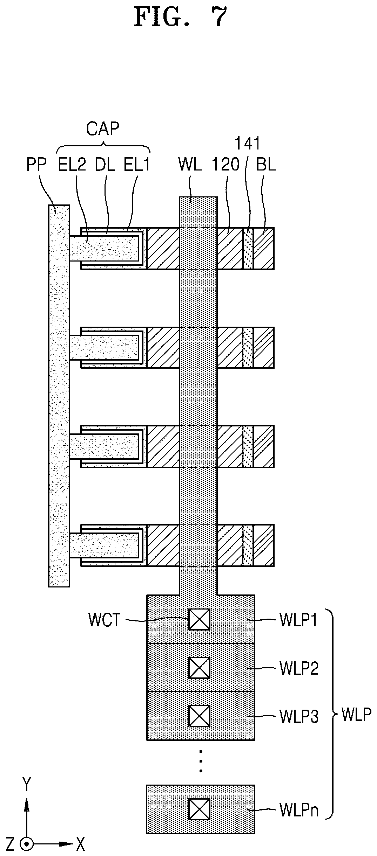

FIG. 7 is a layout view schematically showing a semiconductor memory device according to some example embodiments.

Referring to FIG. 7 together with FIG. 5, the word line WL may extend in the second horizontal direction Y to intersect the first horizontal direction X that is the direction in which the semiconductor pattern 120 extends. A word line pad WLP may be located at the end of the word line WL. As illustrated in FIG. 7, a plurality of word line pads WLP may be arranged sequentially in the second horizontal direction Y. Also, as illustrated in FIG. 5, a plurality of word line pads WLP may be arranged in a step shape in the second horizontal direction Y.

In some example embodiments, a word line pad WLP1 connected to a word line WL located at the top, a second word line pad WLP2 connected to a word line WL located below the top word line WL, and a third word line pad WLP3 connected to a word line WL located below the top two word lines WL may be arranged in this order in the second horizontal direction Y. In this way, a word line pad WLPn connected to an nth word line WL from the top may be arranged in the second horizontal direction Y.

A word line contact WCT may be disposed on the upper surface of each of the word line pads WLP, and the word line WL may be electrically connected to the upper wiring structure 150 via the word line contact WCT.

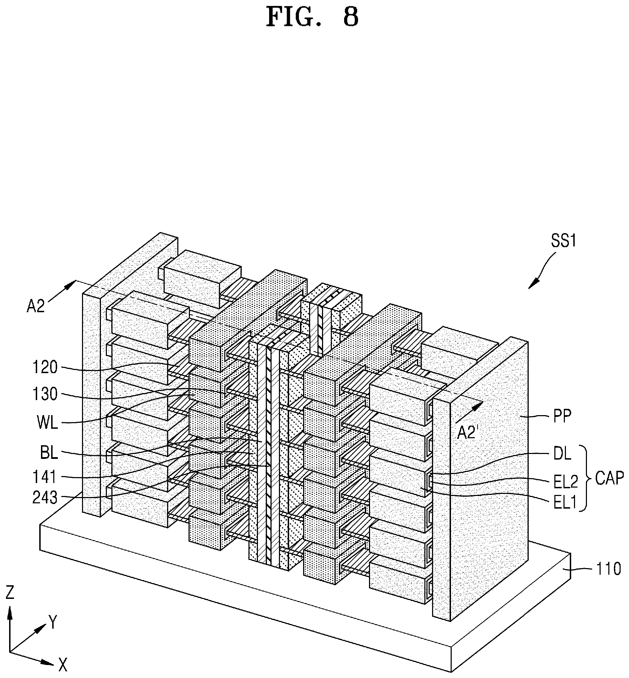

FIG. 8 is a schematic perspective view showing a memory cell region of a semiconductor memory device 20 according to some example embodiments.

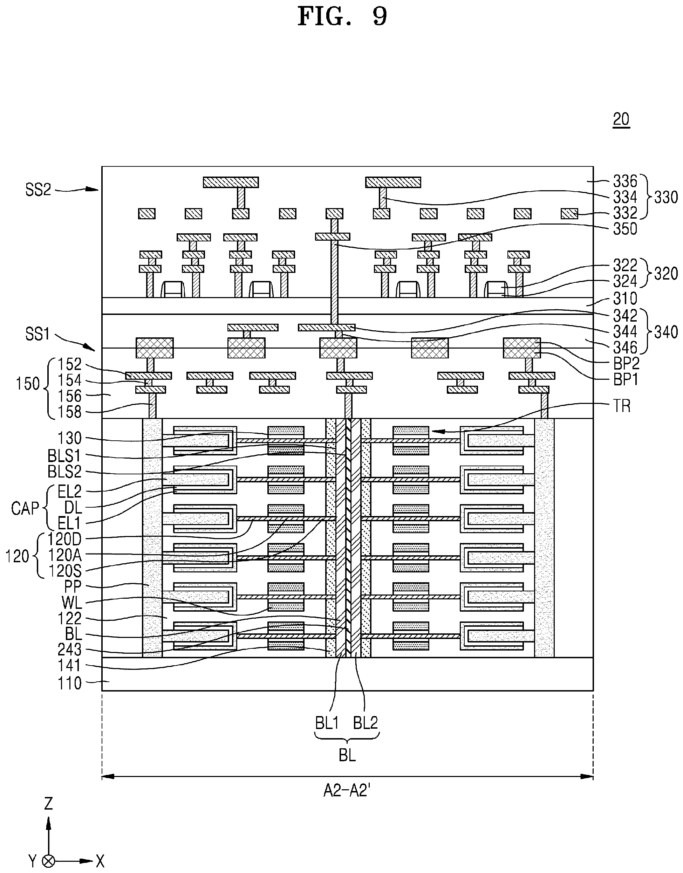

FIG. 9 is a cross-sectional view of the semiconductor memory device 20 taken along line A2-A2' of FIG. 8.

In describing the semiconductor memory device 20 of FIGS. 8 and 9, the same reference numerals as those of the semiconductor memory device 10 described with reference to FIGS. 1 to 7 represent substantially the same components, and repeated descriptions thereof are omitted.

Referring to FIGS. 8 and 9, a plurality of bit lines BL may each extend in a vertical direction Z above a first substrate 110 and may be spaced apart from each other in a second horizontal direction Y. In this case, the bit line BL may include metal.

In some example embodiments, an isolation-insulating layer 243 may pass through the bit line BL in the vertical direction Z. The bit lines BL may include a first bit line BL1 and a second bit line BL2 that are spaced apart from each other with the isolation-insulating layer 243 therebetween. The isolation-insulating layer 243 may electrically isolate the first bit line BL1 from the second bit line BL2. Herein, the isolation-insulating layer 243 may include silicon oxide, silicon oxynitride, silicon nitride, carbon-containing silicon oxide, carbon-containing silicon oxynitride, carbon-containing silicon nitride, or a combination thereof. However, example embodiments are not limited thereto.

In some example embodiments, each of the bit lines BL may include a first sidewall BLS1 and a second sidewall BLS2 opposite to the first sidewall BLS1 in a first horizontal direction X. A spacer layer 141 may extend in the vertical direction Z on the first sidewall BLS1 of the bit line BL. The isolation-insulating layer 243 may extend in the vertical direction Z on the second sidewall BLS2 of the bit line BL. The isolation-insulating layer 243 may be spaced apart from the spacer layer 141 in the first horizontal direction X with the bit line BL therebetween.

In some example embodiments, the spacer layer 141 may be located between the bit line BL and a semiconductor pattern 120. Specifically, the spacer layer 141 may be located between the bit line BL and a source region 120S. The spacer layer 141 may cover the first sidewall BLS1 of the bit line BL and may partially cover the source region 120S. For example, the spacer layer 141 may cover a portion of the upper surface and a portion of the lower surface of the source region 120S. In some example embodiments, a spacer layer 141 may surround one end of the source region 120S. The spacer layer 141 may at least partially wrap around the source region 120S. For example, the spacer layer 141 may cover a portion of the upper surface, a portion of the lower surface, and a portion of the sidewall of the source region 120S. That is, the source region 120S may pass through the spacer layer 141 and one end thereof may be connected to the bit line BL.

In some example embodiments, the source region 120S and drain region 120D of the semiconductor pattern 120 may be doped with first impurities. The channel region 120A may be doped with second impurities that are different from the first impurities. For example, the source region 120S and the drain region 120D may each be of a first conductivity type due to the first impurities, and the channel region 120A may be of a second conductivity type that is different from the first conductivity type due to the second impurities.

In some example embodiments, the first conductivity type may represent n type and the second conductivity type may represent p type, but example embodiments are not limited thereto. For example, the first conductivity type may represent p type and the second conductivity type may represent n type. When the first conductivity type represents n type, the first impurities may include phosphorus (P), arsenic (As), or antimony (Sb). Also, when the second conductivity type represents p type, the second impurities may include boron (B), aluminum (Al), gallium (Ga), or indium (In). For example, the source region 120S and drain region 120D of the semiconductor pattern 120 may be doped with phosphorus (P). However, example embodiments are not limited thereto.

In some example embodiments, the spacer layer 141 may include an insulating material containing a high concentration of impurities. For instance, the spacer layer 141 may have a higher concentration of impurities than the source region 120S. The impurities in the spacer layer 141 may be the same as the impurities in the source region 120S. For example, the spacer layer 141 may include the first impurities. The concentration of first impurities in the spacer layer 141 may be higher than the concentration of first impurities in the source region 120S.

In some example embodiments, the spacer layer 141 may include a high concentration of phosphorus (P). For example, the spacer layer 141 may include PSG. When the spacer layer 141 includes PSG, the source region 120S may be of n type as the first conductivity type.

In some example embodiments, the spacer layer 141 may include a high concentration of boron (B). For example, the spacer layer 141 may include BSG. When the spacer layer 141 includes BSG, the source region 120S may be of p type as the first conductivity type.

In some example embodiments, the concentration of impurities in the spacer layer 141 may be higher than the concentration of impurities in the source region 120S. For example, the first concentration, which is a concentration of phosphorus (P) in the spacer layer 141, may be higher than a second concentration, which is a concentration of phosphorus (P) in the source region 120S. Also, a third concentration, which is a concentration of boron (B) in the spacer layer 141, may be higher than a fourth concentration, which is a concentration of boron (B) in the source region 120S. Since the concentration of impurities in the spacer layer 141 is higher than the concentration of impurities in the source region 120S, the impurities (e.g., phosphorus or boron) may diffuse from the spacer layer 141 to the source region 120S.

In some example embodiments, the semiconductor memory device 20 according to the inventive concepts may include the spacer layer 141 containing a high concentration of impurities, and the spacer layer 141 is adjacent to the source region 120S. Accordingly, the source region 120S may be doped with impurities by the spacer layer 141. In a semiconductor memory device according to a comparative example, a source region is formed using only GPD. Accordingly, the reliability of the semiconductor memory device is degraded due to impurity loss during a process (e.g., heat treatment). In the semiconductor memory device 20 according to some example embodiments of the inventive concepts, impurities are continuously supplied to the source region 120S by using the spacer layer 141 containing a high concentration of impurities. Accordingly, the reliability of the semiconductor memory device 20 may be improved.

Also, the source region 120S is doped with impurities by using the spacer layer 141, and the resistance of the bit line BL may be lowered by using the bit line BL including metal.

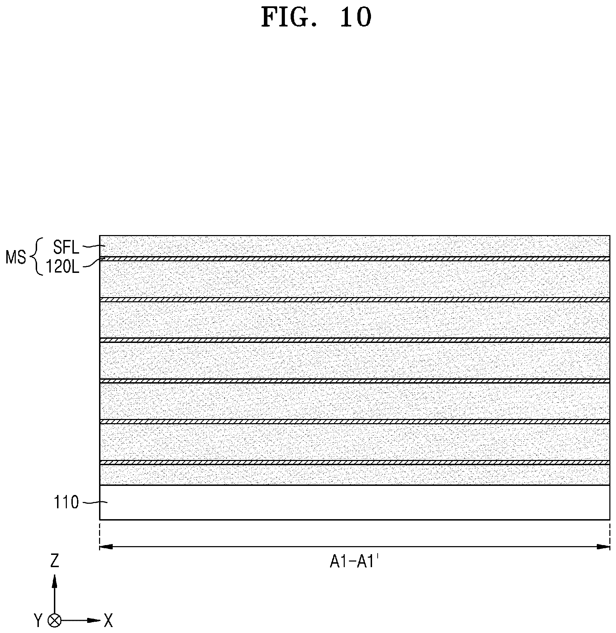

FIGS. 10 to 16 are schematic views showing a method of manufacturing a semiconductor memory device, according to some example embodiments.

Referring to FIG. 10, a sacrificial mold layer SFL and a semiconductor layer 120L may be alternately and sequentially formed on a first substrate 110 to thereby form a mold stack MS.

In some example embodiments, the sacrificial mold layer SFL and the semiconductor layer 120L may include materials having an etching selectivity with respect to each other. For example, the sacrificial mold layer SFL and the semiconductor layer 120L may each include a single crystalline layer of a group IV semiconductor, a group II-VI compound semiconductor, or a group III-V compound semiconductor, and the sacrificial mold layer SFL and the semiconductor layer 120L may include different materials. In some example embodiments, the sacrificial mold layer SFL may include SiGe, and the semiconductor layer 120L may include single crystalline silicon. The sacrificial mold layer SFL and the semiconductor layer 120L may each have the thickness of several tens of nm.

In some example embodiments, the sacrificial mold layer SFL and the semiconductor layer 120L may be formed by an epitaxy process. For example, the epitaxy process may include vapor-phase epitaxy (VPE), a chemical vapor deposition (CVD) process, such as ultra-high vacuum (UHV) CVD, molecular beam epitaxy, or a combination thereof. During the epitaxy process, a liquid or gaseous precursor may be used as a precursor to form the sacrificial mold layer SFL and the semiconductor layer 120L.

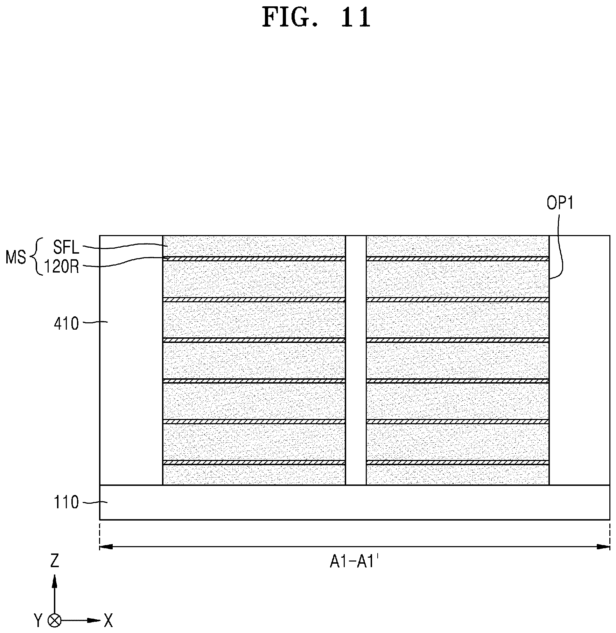

Referring to FIG. 11, a mask pattern (not shown) may be formed on the mold stack MS, and the mold stack MS may be partially removed by using the mask pattern as an etch mask to form a first opening OP1. Subsequently, a first insulating layer 410 may be formed inside the first opening OP1.

In some example embodiments, a plurality of semiconductor patterns 120 may be formed from the semiconductor layer 120L by forming the first opening OP1. Herein, the plurality of semiconductor patterns 120 may be formed by patterning portions of the semiconductor layer 120L.

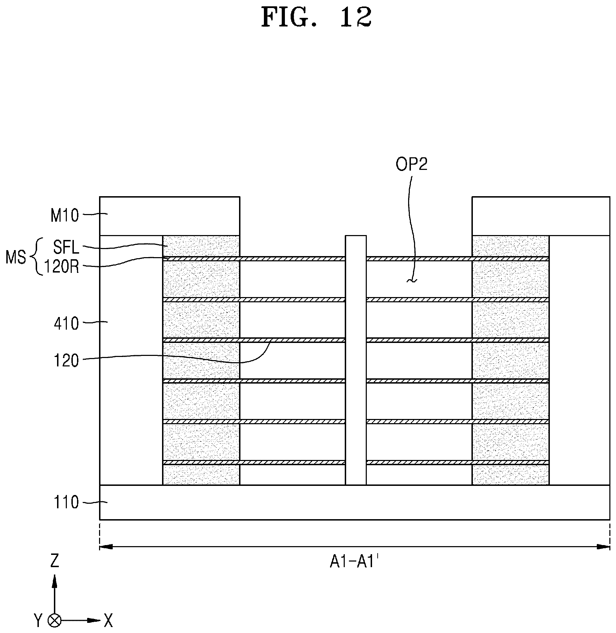

Referring to FIG. 12, the sacrificial mold layers SFL may be removed to form second openings OP2 between the plurality of semiconductor patterns 120.

In some example embodiments, a mask pattern M10 is formed on the mold stack MS, a portion of the sacrificial mold layer SFL not covered by the mask pattern M10 may be removed, and portions of the sacrificial mold layer SFL located at positions vertically overlapping the mask pattern M10 may not be removed but remain. Herein, the portion of the semiconductor pattern 120 covered by the sacrificial mold layer SFL is referred to as a residual pattern 120R. The mask pattern M10 may be disposed on a structure in which the residual pattern 120R and the sacrificial mold layer SFL are alternately stacked on each other.

In some example embodiments, a process of removing the sacrificial mold layer SFL may include a wet etching process or a pull-back process. For example, the process of removing the sacrificial mold layer SFL may include an etching process using the etch selectivity between the sacrificial mold layer SFL and the semiconductor layer 120L. For example, in the wet etching process or the pull-back process, the etching speed on the plurality of semiconductor patterns 120 may be relatively low, and the etching speed on the sacrificial mold layer SFL may be relatively high.

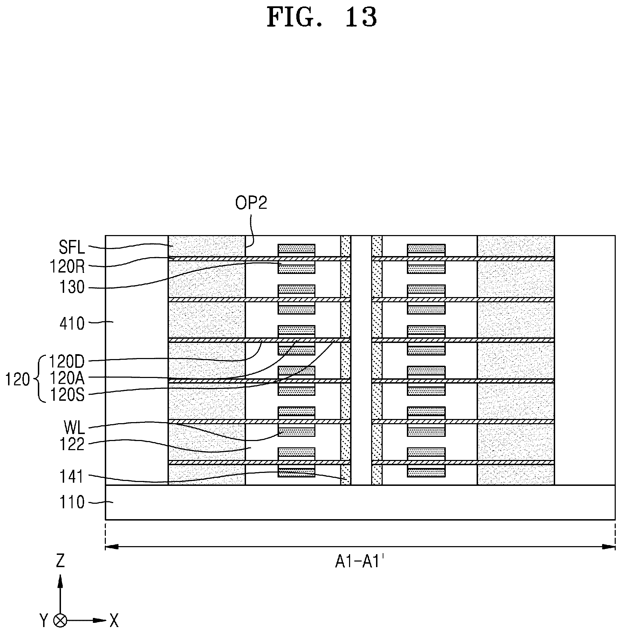

Referring to FIG. 13, a gate insulating layer 130 and a word line WL may be sequentially formed on the upper surface, side surface, and bottom surface of each of the plurality of semiconductor patterns 120 inside the second opening OP2.

For example, the gate insulating layer 130 may conformally surround each of the plurality of semiconductor patterns 120, and the word line WL may surround each of the plurality of semiconductor patterns 120 and extend in the second horizontal direction Y on the gate insulating layer 130.

In some example embodiments, the gate insulating layer 130 and the word line WL located at both ends (e.g., both ends in the first horizontal direction X) of each of the plurality of semiconductor patterns 120 inside the second opening OP2 may be partially removed. In some example embodiments, a protective layer (not shown) covering both ends of the plurality of semiconductor patterns 120 inside the second opening OP2 may be formed first, a gate insulating layer 130 and a word line WL surrounding central portions of the plurality of semiconductor patterns 120 may be formed, and then the protective layer may be removed. Accordingly, both ends of the plurality of semiconductor patterns 120 may not be covered by the gate insulating layer 130 and the word line WL but exposed again.

Subsequently, a spacer layer 141 may be formed to partially cover the semiconductor pattern 120. The spacer layer 141 may extend in a vertical direction Z while surrounding each end of the plurality of semiconductor patterns 120 spaced apart from each other in the vertical direction Z. For example, the spacer layer 141 may cover a portion of the upper surface and a portion of the lower surface of the semiconductor pattern 120. In some example embodiments, a spacer layer 141 may surround one end of the semiconductor pattern 120. The spacer layer 141 may at least partially wrap around the semiconductor pattern 120. For example, the spacer layer 141 may cover a portion of the upper surface, a portion of the lower surface, and a portion of the sidewall(s) of the semiconductor pattern 120. That is, the semiconductor pattern 120 may pass through the spacer layer 141.

Subsequently, a source region 120S and a drain region 120D may be formed. The source region 120S and the drain region 120D may be respectively formed at both ends of the semiconductor pattern 120 that are exposed by partially removing the gate insulating layer 130 and the word line WL.

In some example embodiments, the spacer layer 141 may include an insulating material containing a high concentration of impurities. For example, the spacer layer 141 may include the first impurities.

In some example embodiments, the spacer layer 141 may include a high concentration of phosphorus (P). For example, the spacer layer 141 may include PSG. In some example embodiments, the spacer layer 141 may include a high concentration of boron (B). For example, the spacer layer 141 may include BSG.

Subsequently, the first impurities may be diffused from the spacer layer 141 into the semiconductor pattern 120. Herein, the process of diffusing the first impurities may include a heat treatment process. As the first impurities diffuse into the semiconductor pattern 120, a source region 120S may be formed in a portion of the semiconductor pattern 120 adjacent to the spacer layer 141. Herein, the impurities in the spacer layer 141 may be the same as the impurities in the source region 120S.

For example, when the spacer layer 141 includes PSG, the source region 120S may be doped with phosphorus (P), and thus, the source region 120S may be of n type as the conductivity type. When the spacer layer 141 includes BSG, the source region 120S may be doped with boron (B), and thus, the source region 120S may be of p type as the conductivity type.

In some example embodiments, after the process of diffusing impurities into the source region 120S by using the spacer layer 141, a gas phase doping process may be further performed.

In some example embodiments, the source region 120S and the drain region 120D may be formed by doping, with impurities, both ends of the semiconductor pattern 120 through the gas phase doping. For example, when the source region 120S is doped with n-type impurities by using the PSG, the source region 120S and the drain region 120D may be additionally doped with n-type impurities through a gas phase process. For example, when the source region 120S is doped with p-type impurities by using the BSG, the source region 120S and the drain region 120D may be additionally doped with p-type impurities through a gas phase process. The process of doping the source region 120S through the gas phase process may be omitted.

In some example embodiments, the semiconductor memory devices 10 according to the inventive concepts each include the spacer layer 141 containing a high concentration of impurities, and the spacer layer 141 is adjacent to the source region 120S. Accordingly, the source region 120S may be doped with impurities by the spacer layer 141. The impurities are continuously supplied to the source region 120S by using the spacer layer 141 containing a high concentration of impurities. Accordingly, the reliability of the semiconductor memory devices 10 may be improved.

Also, the source region 120S is doped with impurities by using the spacer layer 141, and the resistance of the bit line BL may be lowered by using the bit line BL including metal.

Subsequently, a mold insulating layer 122 may be formed to fill the inside of the second opening OP2. In some example embodiments, the mold insulating layer 122 may be located between two adjacent word lines WL in the vertical direction Z and between ends of two adjacent semiconductor patterns 120 in the vertical direction Z.

In some example embodiments, the word line WL may be removed to form a word line pad WLP (see FIG. 5). The word line pads WLP may be arranged in a step shape. For example, a word line pad WLP connected to one word line WL may be spaced apart in the second horizontal direction Y from another word line pad WLP that is connected to another word line WL below the one word line WL.

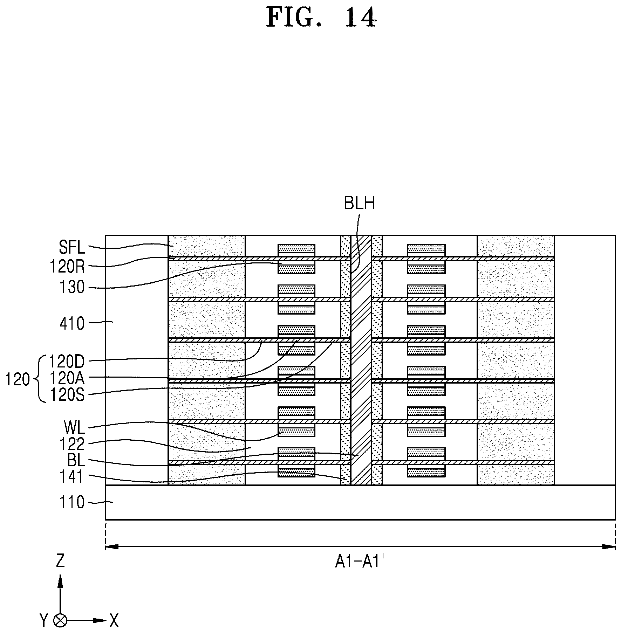

Referring to FIG. 14, a first insulating layer 410 may be partially removed to form a bit line opening BLH, and the bit line BL may be formed inside the bit line opening BLH.

In some example embodiments, two semiconductor patterns 120 may be spaced apart from each other in the first horizontal direction X with the bit line BL therebetween. One sidewall of one bit line BL may be in contact with a source region 120S of one semiconductor pattern 120, and the other sidewall of the one bit line BL may be in contact with a source region 120S of another semiconductor pattern 120. That is, two semiconductor patterns 120 arranged at the same vertical level may be electrically connected to one bit line BL, but the inventive concepts are not limited thereto. For example, the isolation-insulating layer 243 (see FIG. 9) may be formed passing through the bit line BL in the vertical direction Z, and thus, the first bit line BL1 (see FIG. 9) and the second bit line BL2 (see FIG. 9) that are spaced apart from each other with the isolation-insulating layer 243 therebetween may be electrically separated from each other.

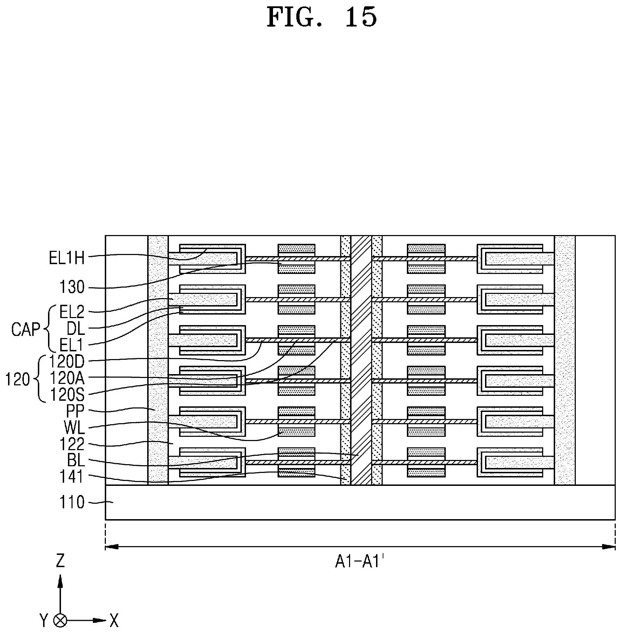

Referring to FIG. 15, the sacrificial mold layer SFL and the residual pattern 120R may be removed, and a cell capacitor CAP may be formed at the location at which the sacrificial mold layer SFL and the residual pattern 120R have been removed.

In some example embodiments, the cell capacitor CAP may include a first electrode EL1, a capacitor dielectric layer DL, and a second electrode EL2. The first electrode EL1 may be electrically connected to the drain region 120D of the semiconductor pattern 120 and may have an inner space EL1H extending in the first horizontal direction X. The capacitor dielectric layer DL may be conformally arranged inside the inner space EL1H, and the inner space EL1H may be filled with the second electrode EL2.

Subsequently, a plate electrode PP may be formed, which is electrically connected to the second electrode EL2 and extends in the second horizontal direction Y.

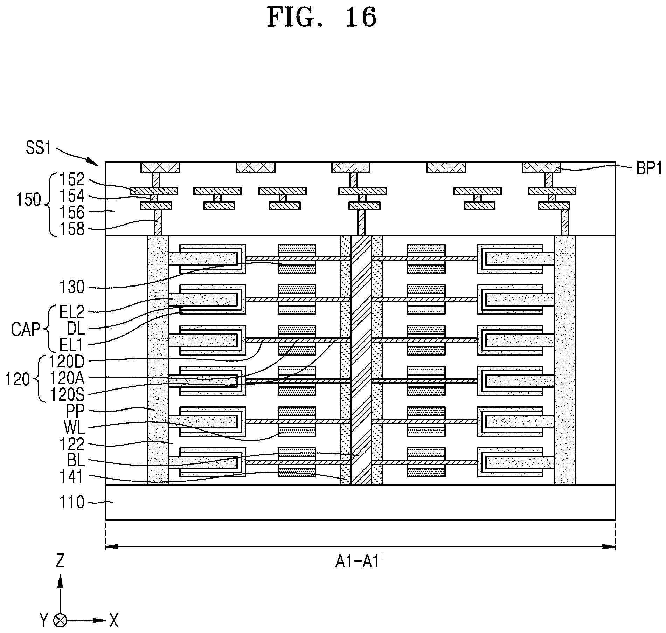

Referring to FIG. 16, an upper wiring structure 150 may be formed. The upper wiring structure 150 may include a wiring layer 152, a via 154, an insulating layer 156, and a contact 158. For example, the contact 158 may be electrically connected to the bit line BL, the word line WL, and the plate electrode PP. Subsequently, a first bonding pad BP1 may be formed on the upper wiring structure 150 and may be on the same plane as the uppermost surface of the insulating layer 156.

Referring back to FIGS. 4 and 5, a second stack structure SS2 may be prepared.

In some example embodiments, the second stack structure SS2 may include a second substrate 310, a peripheral circuit transistor 320 disposed on the second substrate 310, a front wiring structure 330 covering the peripheral circuit transistor 320 on the upper surface of the second substrate 310, and a rear wiring structure 340 disposed on the bottom surface of the second substrate 310.

In some example embodiments, the peripheral circuit transistor 320 is formed on a first surface (or an upper surface) of the second substrate 310, the front wiring structure 330 is formed on the first surface of the second substrate 310, and a carrier substrate is attached to the front wiring structure 330. Subsequently, a second surface (or bottom surface) of the second substrate 310 may be ground to thin the second substrate 310. Subsequently, the second stack structure SS2 may be completed by forming the rear wiring structure 340 and the second bonding pad BP2 on the second surface of the second substrate 310.

Subsequently, the second stack structure SS2 and the first stack structure SS1 may be bonded to each other. In this case, the first bonding pad BP1 of the first stack structure SS1 may be bonded to the second bonding pad BP2 of the second stack structure SS2, and the upper surface of the upper insulating layer 156 may be bonded to the bottom surface of the insulating layer 346.

While specific embodiments are described in which the first and second directions are horizontal directions (e.g. parallel to an upper surface of the first substrate 110) and the third direction is a vertical direction, alternative embodiments may have different arrangements of directions. For instance, the first direction may be a vertical direction and the second and third directions may be horizontal directions. Alternatively, the second direction may be a vertical direction and the first and third directions may be horizontal directions. For instance, the word lines may run vertically, and the bit lines may run horizontally.

While certain embodiments are described in which memory cells are formed using cell capacitors as storage devices, alternative embodiments may utilize alternative storage devices. For instance, the storage device may be a memory element using a capacitor, a memory element using a magnetic tunnel junction (MTJ) pattern, or a memory element using a variable resistor containing a phase-change material. The storage device (e.g. the memory element) may be connected to the drain region of a corresponding semiconductor pattern. Accordingly, while specific embodiments include a DRAM device, alternative embodiments may relate to a magnetoresistive RAM (MRAM) device, a resistive RAM (reRAM) device, or a phase change memory (PCM). Generally, embodiments may relate to RAM devices.

Embodiments are set out in the following Clauses:
Clause 1. A semiconductor memory device comprising:
   a first stack structure comprising
      a memory cell region comprising a plurality of memory cells and a plurality of cell capacitors arranged in three dimensions; and
      a second stack structure
         on the first stack structure,
         the second stack structure comprising a peripheral circuit region located at a position vertically overlapping the plurality of memory cells, and
         the second stack structure electrically connected to the plurality of memory cells,
   wherein the first stack structure comprises
      a first substrate,
      a first semiconductor pattern and a second semiconductor pattern,
      the first semiconductor pattern and the second semiconductor pattern extending in a first horizontal direction above the first substrate, and spaced apart from each other in a second horizontal direction and a vertical direction, the second horizontal direction and the vertical direction intersecting the first horizontal direction,
      the first semiconductor pattern comprising
         a channel region,
         a source region, and
         a drain region,
      the channel region, source region, and drain region arranged in the first horizontal direction with the channel region therebetween,
   a word line surrounding the first semiconductor pattern and extending in the second horizontal direction,
   a bit line connected to the source region of the first semiconductor pattern and extending in the vertical direction,
   the plurality of cell capacitors each connected to the drain region of the first semiconductor pattern,
   a spacer layer located on a sidewall of the bit line and partially covering the source region of the first semiconductor pattern, and
   the source region of the first semiconductor pattern comprising same impurities as impurities of the spacer layer.
Clause 2. The semiconductor memory device of Clause 1, wherein
   the impurities in the spacer layer and the source region of the first semiconductor pattern comprise phosphorus (P), and
   the source region of the first semiconductor pattern has n-type conductivity.
Clause 3. The semiconductor memory device of Clause 1, wherein
   the impurities in the spacer layer and the source region of the first semiconductor pattern comprise boron (B), and
   the source region of the first semiconductor pattern has p-type conductivity.
Clause 4. The semiconductor memory device of any of Clauses 1-3, wherein
   a concentration of the impurities in the spacer layer is a first concentration,
   a concentration of the impurities in the source region of the first semiconductor pattern is a second concentration, and
   the first concentration is higher than the second concentration.
Clause 5. The semiconductor memory device of any of Clause 1-4, further comprising:
   an isolation-insulating layer passing through the bit line in the vertical direction.

While the inventive concepts has been particularly shown and described with reference to embodiments thereof, it will be understood that various changes in form and details may be made therein without departing from the scope of the following claims.

## Claims

1. A semiconductor memory device comprising:
a first substrate (110);
a first semiconductor pattern and a second semiconductor pattern;
the first semiconductor pattern and the second semiconductor pattern
extending in a first horizontal direction above the first substrate, and
spaced apart from each other in a second horizontal direction and a vertical direction, the second horizontal direction and vertical direction intersecting the first horizontal direction;
the first semiconductor pattern comprising
a channel region (120A),
a source region (120S), and
a drain region (120D);
the channel region (120A), source region (120S), and drain region (120D) arranged in the first horizontal direction with the channel region (120A) therebetween;
a first word line and a second word line;
the first word line and the second word line
extending in the second horizontal direction above the first semiconductor pattern, and
spaced apart from each other in the vertical direction;
a bit line (BL) connected to the source region (120S) of the first semiconductor pattern, and the bit line (BL) extending in the vertical direction;
a cell capacitor (CAP) connected to the drain region (120D) of the first semiconductor pattern; and
a spacer layer (141) located between the first semiconductor pattern and the bit line (BL), and the spacer layer (141) comprising a high concentration of impurities.

2. The semiconductor memory device of claim 1, wherein the spacer layer (141) is located on a sidewall of the bit line (BL) and partially covers the source region (120S) of the first semiconductor pattern.

3. The semiconductor memory device of claim 1 or claim 2, wherein the source region (120S) of the first semiconductor pattern passes through the spacer layer (141) and is connected to the bit line (BL).

4. The semiconductor memory device of any preceding claim, wherein the source region (120S) of the first semiconductor pattern comprises same impurities as impurities of the spacer layer (141).

5. The semiconductor memory device of claim 4, wherein
a concentration of the impurities in the spacer layer (141) is a first concentration,
a concentration of the impurities in the source region (120S) of the first semiconductor pattern is a second concentration, and
the first concentration is higher than the second concentration.

6. The semiconductor memory device of any preceding claim, wherein the impurities comprise phosphorus.

7. The semiconductor memory device of any preceding claim, wherein the bit line (BL) comprises metal.

8. The semiconductor memory device of any preceding claim, further comprising:
an isolation-insulating layer (243) passing through the bit line in the vertical direction.

9. The semiconductor memory device of any preceding claim, wherein the first word line surrounds the first semiconductor pattern and extends in the second horizontal direction.

10. The semiconductor memory device of any preceding claim, further comprising:
a gate-insulating layer (130) located between the first semiconductor pattern and the first word line; and
the gate-insulating layer (130) conformally covering the channel region (120A) of the first semiconductor pattern.

11. The semiconductor memory device of claim 1, comprising:
a first stack structure comprising
a memory cell region comprising a plurality of memory cells and a plurality of cell capacitors arranged in three dimensions; and
a second stack structure
on the first stack structure,
the second stack structure comprising a peripheral circuit region located at a position vertically overlapping the plurality of memory cells, and
the second stack structure electrically connected to the plurality of memory cells,
wherein the first stack structure comprises the first substrate (110), a plurality of semiconductor patterns comprising the first semiconductor pattern and the second semiconductor pattern, the first word line, the second word line, the bit line (BL), the cell capacitor (CAP), and the spacer layer (141)
wherein the spacer layer (141) is located on a sidewall of the bit line (BL) and partially covers the source region (120S) of the first semiconductor pattern, and
wherein the source region (120S) of the first semiconductor pattern comprises same impurities as impurities of the spacer layer (141).

12. The semiconductor memory device of claim 11, wherein
the impurities in the spacer layer (141) and the source region (120S) of the first semiconductor pattern comprise phosphorus, and
the source region (120S) of the first semiconductor pattern has n-type conductivity.

13. The semiconductor memory device of claim 11, wherein
the impurities in the spacer layer (141) and the source region (120S) of the first semiconductor pattern comprise boron, and
the source region (120S) of the first semiconductor pattern has p-type conductivity.

14. The semiconductor memory device of any of claims 11-13, wherein
a concentration of the impurities in the spacer layer (141) is a first concentration,
a concentration of the impurities in the source region (120S) of the first semiconductor pattern is a second concentration, and
the first concentration is higher than the second concentration.

15. The semiconductor memory device of any of claims 11-14, further comprising:
an isolation-insulating layer (243) passing through the bit line in the vertical direction.
